# EUROPEAN PATENT APPLICATION

(11) **EP 1 860 680 A1**
(43) Date of publication of application: **28.11.2007**
(21) Application number: 07108663.1
(22) Date of filing: 22.05.2007
(51) Int. Cl.: H01J 37/32

(54) **Inductively coupled plasma reactor**

(30) Priority: 22.05.2006 KR 20060045478; 22.05.2006 KR 20060045509; 22.05.2006 KR 20060045833
(71) Applicant: New Power Plasma Co., Ltd., Suwon-si, Gyeonggi-do 443-390 (KR)
(72) Inventor: Choi, Dae-Kyu, Suwon-si, 443-725, Gyeonggi-do (KR)
(74) Representative: Greene, Simon Kenneth

(57) **Abstract**

There is provided a plasma reactor comprising: a vacuum chamber (100) having a substrate support (111) on which a treated substrate (112) is positioned; a gas shower head (140) supplying gas into the interior of the vacuum chamber; a dielectric window (130) installed at an upper portion of the vacuum chamber; and a radio frequency antenna (151) installed above the dielectric window. The gas shower head and the substrate support are capacitively coupled to plasma in the interior of the vacuum chamber and the radio frequency antenna is inductively coupled to the plasma in the interior of the vacuum chamber. The capacitive and inductive coupling of the plasma reactor allows generation of plasma in a large area inside the vacuum chamber more uniformly and more accurate control of plasma ion energy, thereby increasing the yield and the productivity. The plasma reactor includes a magnetic core (150) installed above the dielectric window so that an entrance for a magnetic flux faces the interior of the vacuum chamber and covers the radio frequency antenna. Since the radio frequency antenna is covered by the magnetic core, the magnetic flux can be more strongly collected and the loss of the magnetic flux can be minimized.

## Description

### BACKGROUND OF THE INVENTION

The present invention relates to a radio frequency plasma source, and more particularly, to an inductively coupled plasma reactor capable of uniformly generating plasma of a high density.

Plasma is highly ionized gas including the same number of positive ions and electrons. Plasma discharge is used in gas excitation for generating ions, free radicals, atoms, and molecules. Active gas is widely used in various fields, and particularly is used in semiconductor fabrication processes such as etching, deposition, cleaning, and ashing.

There are various plasma sources for generating plasma, and capacitively coupled plasma using a radio frequency and inductively coupled plasma are

### examples.

The capacitively coupled plasma source can accurately regulate the capacitive coupling and excellently regulate ions, so that it has a high process productivity as compared to other plasma sources. Meanwhile, since the energy of a radio frequency power source is connected to plasma through the capacitive coupling almost exclusively, the density of the plasma ions can be increased or decreased only by the increase or decrease on the electric power of the capacitively coupled radio frequency. However, the increase on the electric power of the radio frequency causes ion impact energy. As a result, the electric power of the radio frequency is limited to prevent damage due to an ion impact.

On the other hand, the inductively coupled plasma source can easily increase the density of ions by increasing a radio frequency power source and is known to be suitable for high density plasma since the ion impact is relatively low. Therefore, the inductively coupled plasma source is generally used to obtain plasma of a high density. The technology of the inductively coupled plasma source has been developed as a method using a radio frequency antenna (RF antenna) and a method using a transformer (also, referred to as a transformer coupled plasma). Here, the technology has been developed to improve the characteristics of plasma and to increase the reproducibility and the control ability by adding an electromagnet or a permanent magnet and by adding a capacitive coupling electrode.

A spiral type antenna or a cylinder type antenna are generally used as the radio frequency antenna. The radio frequency antenna is disposed outside the plasma reactor and transfers an inductive electromotive force into the interior of the plasma reactor through a dielectric window such as quartz. The inductive coupling plasma using the radio frequency antenna can easily obtain the plasma of a high density and the uniformity of the plasma is influenced by the structural characteristics of the antenna. Therefore, efforts have been made to obtain the plasma of a high density by improving the structure of the RF frequency antenna.

However, there is a limit in widening the structure of the antenna or in increase the power supplied to the antenna in order to obtain the plasma of a large area. For example, it is known that non-uniform plasma is radially generated by a standing wave effect. Further, the dielectric window should be thick by increasing the capacitive coupling of the radio frequency antenna in the case that high power is applied to the antenna. Accordingly, the distance between the radio frequency antenna and the plasma increases and the power transferring efficiency is lowered.

Recently, in the semiconductor manufacturing industry, a more improved plasma treating technology is required due to the ultra-minuteness of a semiconductor device, the large scale of a silicon wafer substrate for manufacturing semiconductor circuits, the large scale of a glass substrate for manufacturing a liquid crystal display, and appearance of new treated materials. Especially, a plasma source having an excellent treating ability on a treated material of a large area and a plasma treating technology are required.

### SUMMARY OF THE INVENTION

Therefore, the present invention provides a plasma reactor capable of generating plasma of a high density which has a high control ability on plasma ion energy and a uniform large area by employing the advantages of inductively coupled plasma and capacitively coupled plasma.

The present invention also provides a plasma reactor capable of generating plasma of a high density which has a high control ability on plasma ion energy and a uniform large area by improving the magnetic flux transferring efficiency of an antenna.

The present invention also provides a plasma reactor capable of generating uniform plasma of a high density by increasing the transfer efficiency of a magnetic flux from a radio frequency antenna into the interior of a vacuum chamber and by uniformly supplying process gas.

In accordance with one aspect of the present invention, there is provided a plasma reactor comprising: a vacuum chamber having a substrate support on which a treated substrate is positioned; a gas shower head supplying gas into the interior of the vacuum chamber; a dielectric window installed at an upper portion of the vacuum chamber; and a radio frequency antenna installed above the dielectric window. The gas shower head and the substrate support are capacitively coupled to plasma in the interior of the vacuum chamber and the radio frequency antenna is inductively coupled to the plasma in the interior of the vacuum chamber.

In accordance with another aspect of the present invention, there is provided a plasma reactor comprising a vacuum chamber, a dielectric window installed at an upper portion of the vacuum chamber, and a radio frequency antenna installed above the dielectric window, and a magnetic core installed above the dielectric window so that an entrance for a magnetic flux faces the interior of the vacuum chamber and covers the radio frequency antenna.

The capacitive and inductive coupling of the plasma reactor generates plasma to allow generation of plasma in the vacuum chamber and accurate control of plasma ion energy. Since the radio frequency antenna is covered by a magnetic core, the strongly-collected magnetic flux can be transferred into the interior of the vacuum chamber and the loss of the magnetic flux can be minimized.

### BRIEF DESCRIPTION OF THE DRAWINGS

The above and other features and advantages of the present invention will become more apparent to those of ordinary skill in the art by describing in detail preferred embodiments thereof with reference to the attached drawings in which:
FIG. 1 is a cross-sectional view of a plasma reactor according to a first embodiment of the present invention;
FIG. 2 is a view illustrating an assembled structure of a radio frequency antenna installed at an upper portion of the plasma reactor of FIG. 1 and a gas shower head;
FIG. 3 is a view illustrating an electrical connection structure of a radio frequency antenna and a shower head;
FIGS. 4A to 4D are views illustrating various modified examples of an electrical connection structure of a radio frequency antenna and a shower head;
FIG. 5 is a view illustrating an example employing a dual power source supply structure by division of a power source;
FIG. 6 is a view illustrating an example employing a dual power source structure with two power supply sources;
FIGS. 7A and 7B are views exemplifying an electric power control section provided between a radio frequency antenna and the ground;
FIG. 8 is a cross-sectional view of a plasma reactor according to a second embodiment of the present invention;
FIG. 9 is a view illustrating an arrangement structure of a radio frequency antenna installed at an upper portion of the plasma reactor of FIG. 8 and a gas shower head;
FIG. 10 is a view illustrating an example in which a cylindrical radio frequency antenna is also installed on an outer side wall of a vacuum chamber;
FIG. 11 is a cross-sectional view of a plasma reactor according to a third embodiment of the present invention;
FIG. 12 is a view illustrating an arrangement structure of a radio frequency antenna installed at an upper portion of the plasma reactor and a gas shower head;
FIG. 13 is a view illustrating a magnetic field induced in the interior of a vacuum chamber through a dielectric window by a radio antenna and a magnetic core;
FIG. 14 is a view illustrating an example employing a dual power source supply structure by division of a power source;
FIG. 15 is a view illustrating an example employing a dual power source structure by two power supply sources;
FIG. 16 is a cross-sectional view of a plasma reactor illustrating an example employing a plate type magnetic core;
FIG. 17 is an exploded perspective view of a plate type magnetic core, a radio frequency antenna, and a shower head;
FIG. 18 is a cross-sectional view of a plasma reactor according to a fourth embodiment of the present invention;
FIG. 19 is a view illustrating an arrangement structure of a radio frequency antenna installed at an upper portion of the plasma reactor and a gas shower head;
FIG. 20 is a cross-sectional view of a plasma reactor illustrating an example using a plate type magnetic core;
FIG. 21 is a view illustrating an example in which a cylindrical radio frequency antenna and a magnetic core are installed at an outer side wall portion of a vacuum chamber;
FIG. 22 is a cross-sectional view of a plasma reactor according to a fifth embodiment of the present invention;
FIGS. 23A and 23B are views illustrating examples in which a radio frequency antenna has a flat plate spiral shape or a concentric circular shape;
FIGS. 24A and 24B are views illustrating electrical connection structures of radio frequency antennas;
FIG. 25 is a view illustrating an example employing a dual power source supply structure by division of a power source;
FIG. 26 is a view illustrating an example employing a dual power source structure with two power supply sources; and
FIG. 27 is a partial cross-sectional view illustrating a modified example in which a gas supply channel is formed through a central portion of a magnetic core.

### DETAILED DESCRIPTION OF THE INVENTION

Hereinafter, plasma reactors according to embodiments of the present invention will now be described in detail with reference to the accompanying drawings. The embodiments of the present invention can be modified in various forms and the scope of the present invention is not construed to be restricted by the embodiments. The embodiments are provided to those skilled in the art for full understanding of the present invention. Therefore, the shapes of elements in the drawings are exaggerated to stress the definite description. In understanding the drawings, it should be noted that the same members are endowed with the same reference numerals. Further, the detailed description of well-known functions and constitutions which may make the essence of the present invention unclear will not be repeated.

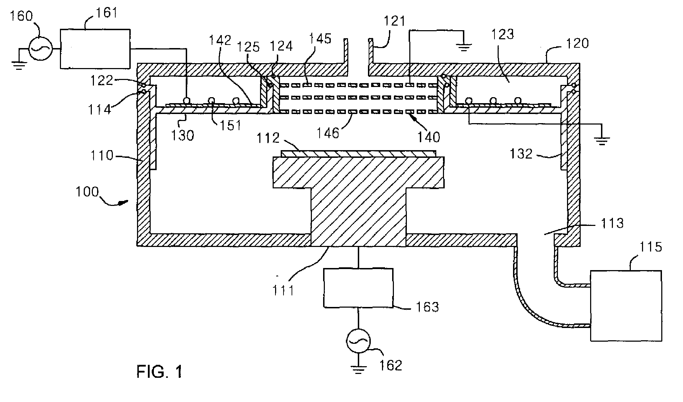

FIG. 1 is a cross-sectional view of a plasma reactor according to a first embodiment of the present invention.

Referring to FIG. 1, the plasma reactor includes a vacuum chamber 100 having a lower body 110 and an upper cover 120. A substrate support 111 on which a treated substrate 112 is positioned is provided in the interior of the vacuum chamber 100. The lower body 110 includes a gas outlet 113 for exhausting gas and the gas outlet 113 is connected to a vacuum pump 115. The treated substrate 112 is a silicon wafer substrate for manufacturing a semiconductor device and a glass substrate for manufacturing a liquid crystal display or a plasma display.

The lower body 110 is formed of a metal material such as aluminum, stainless steel, and copper. Further, the lower body 110 may be formed of a coated material, e.g. anodized aluminum or aluminum coated with nickel. Further, the lower body 110 may be formed of a refractory metal. As an alternative, the lower body 110 may be formed of an electrically insulating material such as quartz and ceramic or of another material suitable for an intended plasma process. The upper cover 120 and the lower body 110 may be formed of a same material or different materials.

A dielectric window 130 having an opened central portion is installed at an upper portion of the vacuum chamber 100 inside the vacuum chamber 100. A gas shower head 140 is installed in the opening of the dielectric window 130. The gas shower head 140 includes at least one gas distribution plate 145 and is formed of a conductive material. A silicon flat plate 146 having a plurality of gas injection holes may be installed in the gas shower head 140 at a section making contact with an interior region of the vacuum chamber 100. A gas inlet 121 connected to the gas shower head 140 is installed at the center of the upper cover 120. A radio frequency antenna 151 is installed in an upper space 123 between the upper cover 120 and the dielectric window 130.

A dielectric wall 132 may be selectively installed along the inner wall of the vacuum chamber 100. It is preferable that the dielectric wall 132 and the dielectric window 130 are integrally formed. However, a structure in which the dielectric wall 132 and the dielectric window 130 are separated. The dielectric wall 132 extends to a portion rather lower than the substrate support 111 to prevent damage to or contamination of the lower body 110 when a process progresses. The dielectric window 130 and the dielectric wall 132 are formed of an insulating material such as quartz and ceramic.

The dielectric window 130 is provided between the upper cover 120 and the lower body 110. Then, O-rings 114 and 122 for vacuum insulation are installed on the bonding surface between the upper cover 120 and the dielectric window 130 and on the bonding surface between the dielectric window 130 and the lower body 110. 0-rings 125 and 124 for vacuum insulation are also installed on the bonding surface between the dielectric window 130 and the shower head 140, and on the bonding surface between the shower head 140 and the cupper cover 120.

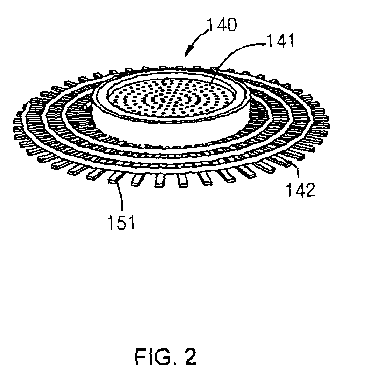

FIG. 2 is a view illustrating an assembled structure of the radio frequency antenna installed at an upper portion of the plasma reactor of FIG. 1 and the gas shower head.

Referring to FIG. 2, the radio frequency antenna 151 is installed about the gas shower head 140 and has a flat surface spiral structure. A faraday shield 142 is installed between the dielectric window 130 and the radio frequency antenna 151. The faraday shield 142 may be selectively installed or may not. The faraday shield 142 may be electrically connected to the gas shower 140 or may not.

Referring to FIG. 1 again, one end of the radio frequency antenna151 is electrically connected to a first power supply source 160 supplying radio frequencies through an impedance matcher 161 and the other end thereof is grounded. The radio frequency antennal 151 is inductively coupled to the plasma in the vacuum chamber. The substrate support 111 is electrically connected to a second power supply source 162 supplying radio frequencies through an impedance matcher 163 and the gas shower head 140 is grounded. The gas shower head 140 and the substrate support 111 constitute a pair of capacitive electrodes and are capacitively coupled to the plasma in the vacuum chamber 100. The first and second power supply sources 160 and 162 may be constituted using a radio frequency power supply source capable of controlling an output voltage without any separate impedance matcher. The relation between the phases of a radio frequency signal for capacitive coupling and a radio frequency signal for inductive coupling is proper. For example, the phase relation of approximately 180 degrees is provided.

In the plasma reactor according to the first embodiment of the present invention, the gas shower head 140 and the substrate support 111 are capacitively coupled to the plasma in the vacuum chamber 100 and the radio frequency antenna 151 is inductively coupled to the plasma in the vacuum chamber 100. Generally, in an inductively coupled plasma source using a radio frequency antenna, the density and the uniformity of plasma are influenced by the shape of the radio frequency antenna. In this point, the plasma reactor according to the present invention can obtain more uniform plasma in the interior of a vacuum chamber by providing the capacitively coupled gas shower head 140 at its central portion and providing the radio frequency antenna 151 disposed in a flat plate spiral shape at its periphery.

The capacitive and inductive coupling allows generation of plasma in the vacuum chamber 100 and accurate control of plasma ion energy. Accordingly, the process productivity is maximized. Further, the substrate can be more uniformly by locating the gas shower head 140 on the upper side of the substrate support 111 and injecting gas uniformly to an upper portion of the treated substrate 112.

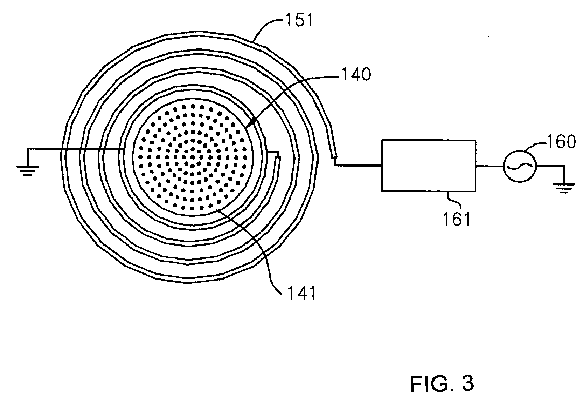

FIG. 3 is a view illustrating an electrical connection structure of a radio frequency antenna and a shower head.

Referring to FIG. 3, the radio frequency antenna 151 and the gas shower head 140 may be electrically connected to each other in series. That is, one end of the radio frequency antenna 151 is connected to a first power supply source 160 through an impedance matcher 161 and the other end thereof is connected to the gas shower head 140. The gas shower head 140 is grounded. The electrical connection between the gas shower head 140 and the radio frequency antenna 151 can be variously modified in the following ways.

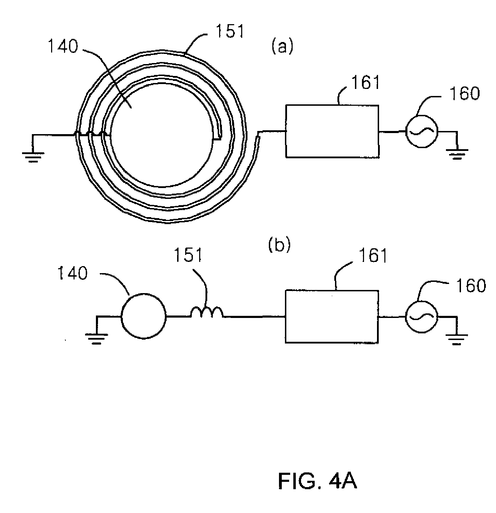

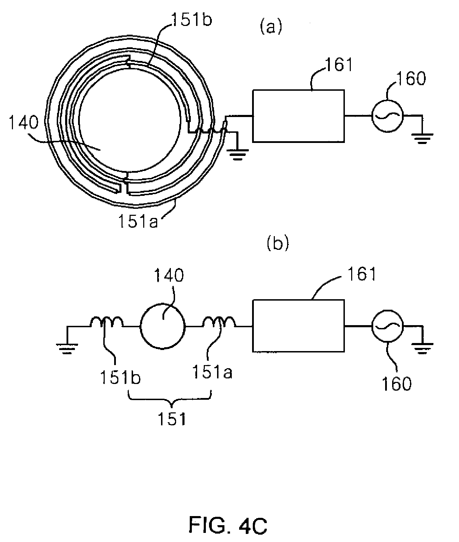

FIGS. 4A and to 4D are views illustrating various modified examples of the electrical connection structure of the radio frequency antenna and the shower head.

The drawings indicated by (a) in FIGS. 4A to 4D illustrate the physical arrangement structures and the electrical connection relations of the radio frequency antenna 151 and the gas shower head 140, and the drawings indicated by (b) illustrates the connection relations with electrical symbols.

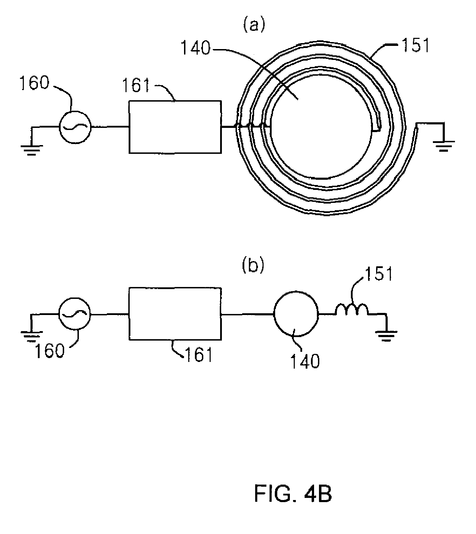

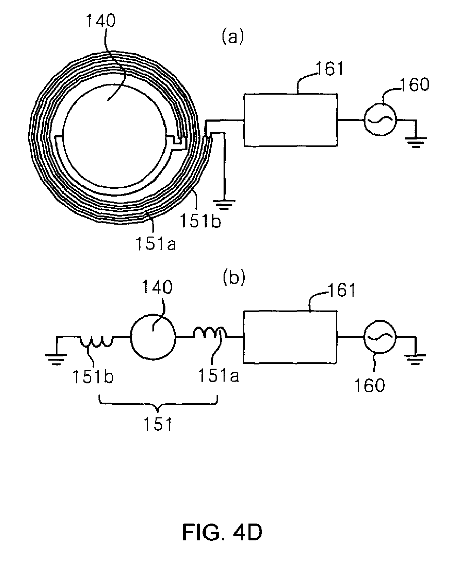

The connection method of the gas shower head 140 and the radio frequency antenna 151 exemplified in FIG. 4A is the same as the method which has been described with reference to FIG. 4. On end of the radio frequency antenna 151 is electrically connected to a first power supply source 160 through an impedance matcher 161 and the other end thereof is electrically connected to the gas shower head 140. The gas shower head 140 is grounded.

In the connection method of the gas shower head 140 and the radio frequency antenna 151 exemplified in FIG. 4B, the gas shower head 140 is electrically connected to a first power supply source 160 first and the radio frequency antenna 161 is connected to the gas shower head 140 and is grounded.

In the connection method of the gas shower head 140 and the radio frequency antenna 151 exemplified in FIGS. 4C and 4D, the radio frequency antenna 151 includes two separated antennas 151 a and 151 b and the gas shower head 140 is electrically connected between them. In FIG. 4C, the two separated antennas 151 a and 151 b of the radio frequency antenna 151 are wound in the same winding direction and are located at the inner periphery and the outer periphery, respectively.

Further, in the radio frequency antenna 151 illustrated in FIG. 4D, the two separated antennas 151a and 151b are wound in parallel in a flat plate spiral shape at the circumference of the gas shower head 140. Further, one end of the outer side of the antenna 151 a located at the outer periphery is connected to a first power supply source 160 through an impedance matcher 161 and the other end thereof is connected to the gas shower head 140. One end of the inner side of the antenna 151 b located at the inner periphery is connected to the gas shower head 140 and one end on the outer side is grounded.

Various electrical connection methods can be employed in addition to the electrical connection methods of the gas shower head 140 and the radio frequency antenna 161 exemplified in FIGS. 4A to 4D. The electrical connection methods can be applied to the following examples in the same way. Further, the power source supply method of the radio frequency antenna 161 and the substrate support 111 can employ various supply methods as will be described later. Further, the number of the power supply sources for supplying radio frequencies may be modified variously.

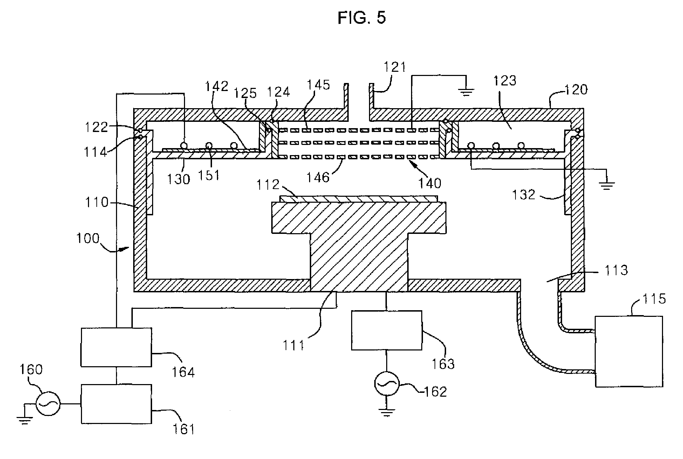

FIG. 5 is a view illustrating an example employing a dual power source supply structure by division of a power source.

Referring to FIG. 5, a power source division and supply structure in which the radio frequency provided from a first power supply source 160 is distributed through a power source distributing section 164 and is supplied to a radio frequency antenna 151 and a substrate support 111. The power source distributing section 164 can divide a power source by various methods such as power source division using a transformer, power source division using a plurality of resistances, and power source division using a capacitor. The substrate support 111 receives the radio frequency divided from a first power supply source 160 and the radio frequency provided from a second power supply source 162. Here, the radio frequencies are different and are supplied from the first and second power supply sources 160 and 162.

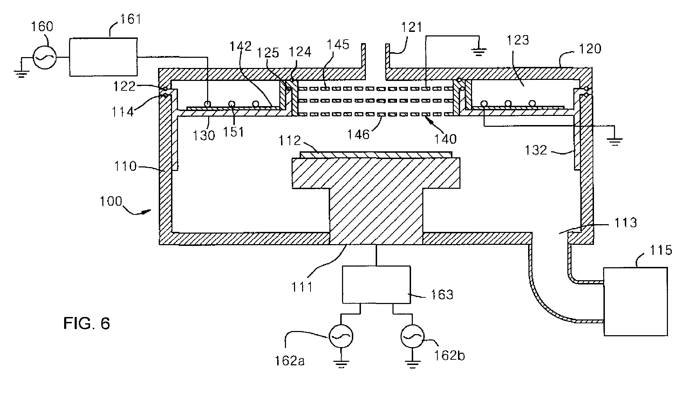

FIG. 6 is a view illustrating an example employing a dual power source structure with two power supply sources.

Referring to FIG. 6, the substrate 111 can receive two radio frequencies through two power supply sources 162a and 162b providing two different frequencies.

If the substrate support 111 receives radio frequencies having different frequencies, various power source supply structure such as a power source division structure or a separate independent power source can be employed. The dual power source supply structure of the substrate support 111 facilitates generation of plasma in the interior of the vacuum chamber 100, improves regulation of plasma ion energy on a surface of the treated substrate 112, and improves the process productivity.

The single or dual power source supply structure of the substrate support 111 is combined with various electrical connection methods of the radio frequency antenna 151 and the gas shower head 140 which has been described in FIGS. 5A and 5D to realize various electrical connection methods.

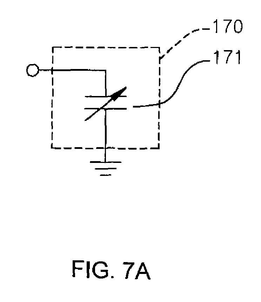

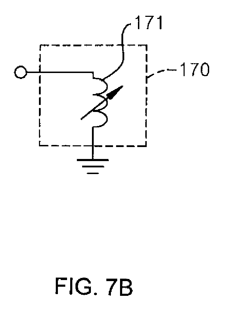

FIGS. 7A and 7B are views exemplifying an electric power control section provided between a radio frequency antenna and the ground.

Referring to FIGS. 7A and 7B, the electric power control section 170 are provided between the radio frequency antenna 151 and the ground. For example, the electric power control section 170 may include a variable capacitor 171 a or a variable inductor 171b. The inductive coupling energy of the radio frequency antenna 151 can be regulated under the control of the variable capacity of the electric power control section 170. The electric power control section 170 may be provided between the gas shower head 140 and the ground to regulate the capacitive coupling energy.

The constitution of the electric power control section 170 is combined with various power source supply structures and various electrical connection methods of the gas shower head 140 and the radio frequency antenna 161 to realize various electrical connection methods. The electrical connection methods can be applied to the examples which will be described later in the same ways.

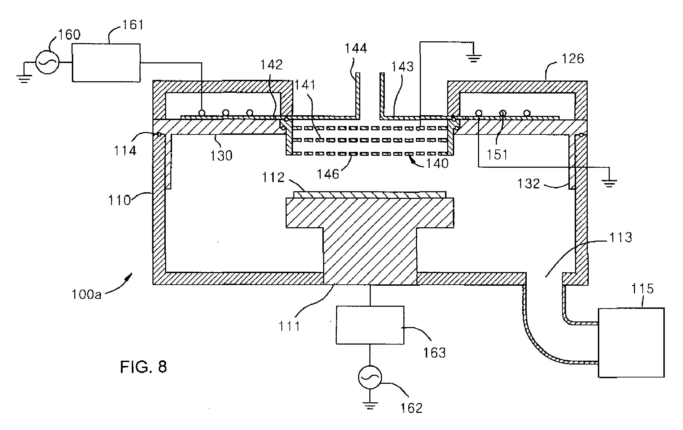

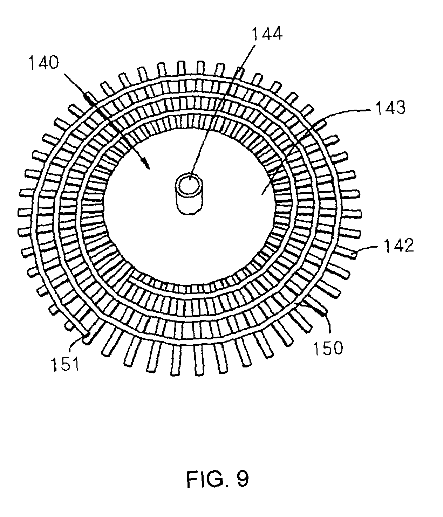

FIG. 8 is a cross-sectional view of a plasma reactor according to a second embodiment of the present invention. FIG. 9 is a view illustrating an arrangement structure of the radio frequency antenna installed at an upper portion of the plasma reactor of FIG. 8 and the gas shower head.

Referring to FIGS. 8 and 9, the plasma reactor according to the second embodiment of the present invention has a structure basically the same as the above-mentioned first embodiment. Therefore, the description of the same constitution will not be repeated. However, in the plasma reactor according to the second embodiment, the structure of the vacuum chamber 100a is rather different from the vacuum chamber 100 of the first embodiment. In the vacuum chamber 100a of the plasma reactor according to the second embodiment, a dielectric window 130 provided at an upper portion of a lower body 110 also functions as an upper cover. A cover member 126 covering the radio frequency antenna 151 entirely is provided at an upper portion of the dielectric window 130. The cover member 126 is formed of a conductive or non-conductive material. A shower head 140 further protrudes toward the substrate support 111 rather than the dielectric window 130.

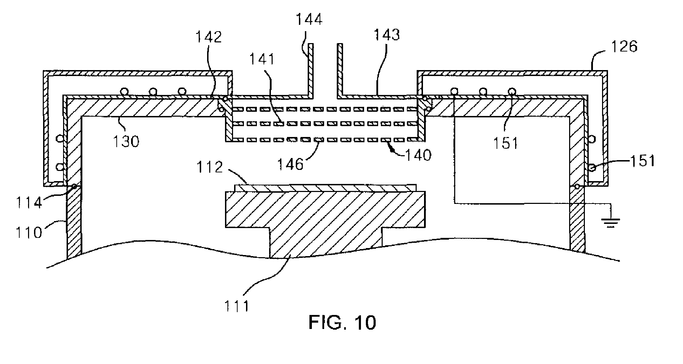

FIG. 10 is a view illustrating an example in which a cylindrical radio frequency antenna is also installed on an outer side wall of the vacuum chamber.

Referring to FIG. 10, the radio frequency antenna 151 has a flat plate spiral structure and is installed above the dielectric window 130. The radio frequency antenna 151 can be installed in a cylindrical structure on the outer side wall of the vacuum chamber 100 as an extended structure. The dielectric window 130 has a structure suitable for this. Further, the cover member also has an extended structure so as to cover the radio frequency antenna 151 installed on the outer wall.

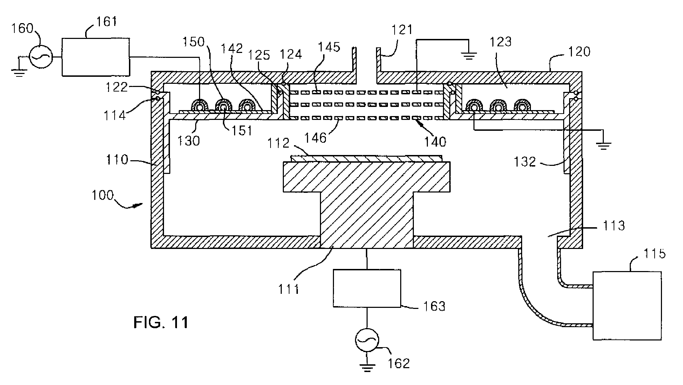

FIG. 11 is a cross-section of a plasma reactor according to a third embodiment of the present invention.

Referring to FIG. 11, the plasma reactor of the third embodiment has a basically same structure as the first embodiment. Therefore, the description of the same constitution will not be repeated. Especially, since in the plasma reactor of the third embodiment, a radio frequency antenna 151 is covered by a magnetic core 150, the magnetic flux can strongly collected and the loss of the magnetic flux can be minimized.

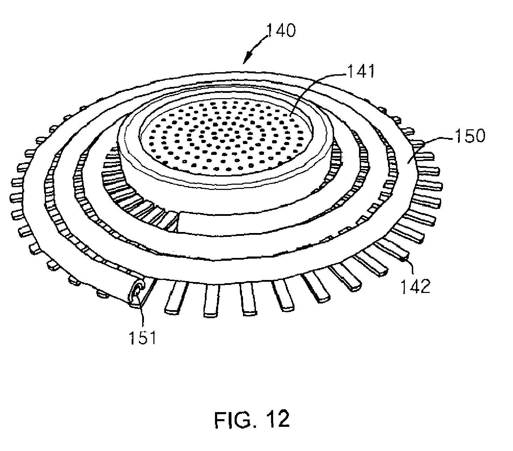

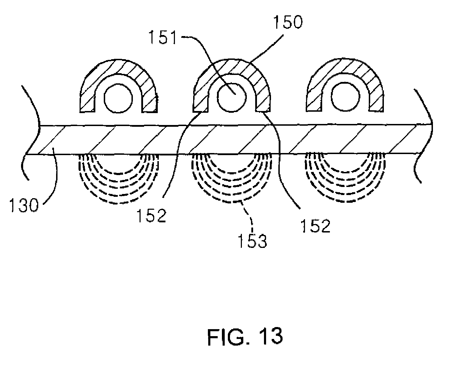

FIG. 12 is a view illustrating an arrangement structure of a radio frequency antenna installed at an upper portion of the plasma reactor and a gas shower head. FIG. 13 is a view visually illustrating a magnetic field induced in the interior of a vacuum chamber through a dielectric window by a radio antenna and a magnetic core.

Referring to FIG. 12, the radio frequency antenna 151 is installed in a flat plate spiral structure about a gas shower head 140 and is covered by the magnetic core 150. The vertical cross-section of the magnetic core 150 has a horseshoe-like shape and is installed so as to be covered along the radio frequency antenna 151 by allowing a magnetic flux entrance opening 152 to face a dielectric window 130. Therefore, as illustrated in FIG. 13, the magnetic flux generated by the radio frequency antenna 151 is collected by the magnetic core 150 and is induced into the vacuum chamber 100 through the dielectric window 130. The magnetic core 150 is formed of a ferrite material and may be formed of another material. The magnetic core 150 may be manufactured by assembling ferrite core pieces having a plurality of horseshoe-likes shapes. Any ferrite core in which the vertical cross-sectional structure has a horseshoe-like shape and is wound in a flat plate spiral shape may be used.

In the plasma reactor according to the third embodiment of the present invention, the gas shower head 140 and the substrate support 111 are capacitively coupled to the plasma in the vacuum chamber and the radio frequency antenna 151 is inductively coupled to the plasma in the vacuum chamber 100. Generally, in an inductively coupled plasma source using a radio frequency antenna, the density and the uniformity of plasma are influenced by the shape of the radio frequency antenna. In this point, the plasma reactor according to the present invention can obtain more uniform plasma in the interior of a vacuum chamber by providing the capacitively coupled gas shower head 140 at its central portion and providing the radio frequency antenna 151 disposed in a flat plate spiral shape at its periphery. Especially, since the radio frequency antenna 151 is covered by the magnetic core 150, the magnetic flux can be strongly collected and the loss of the magnetic flux can be minimized.

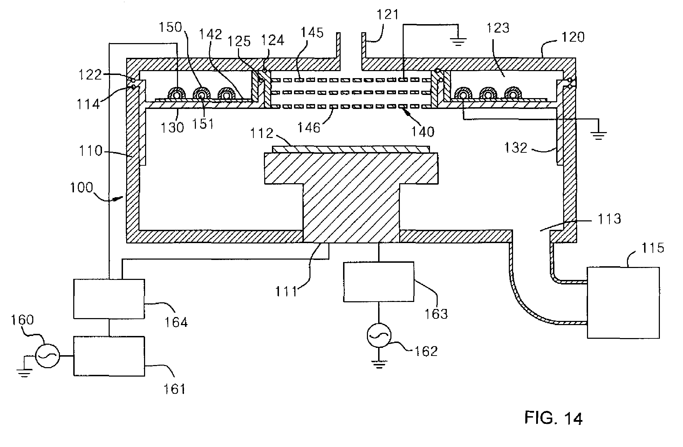

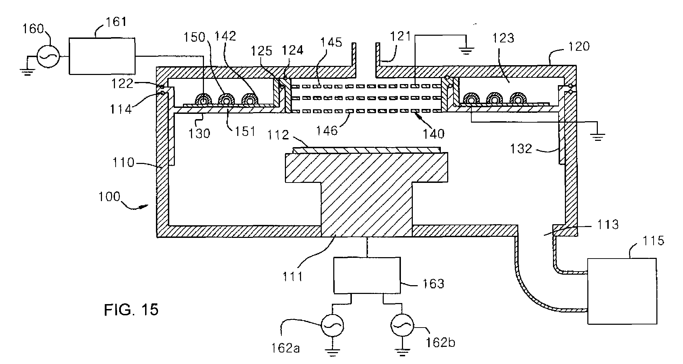

FIG. 14 is a view illustrating an example employing a dual power source supply structure by division of a power source. FIG. 15 is a view illustrating an example employing a dual power source structure by two power supply sources.

The plasma reactor exemplified in FIGS. 14 and 15 has a basically same structure as the plasma reactor of FIGS. 5 and 6. Especially, in the plasma reactor exemplified in FIGS. 14 and 15, since a radio frequency antenna 151 is covered by a magnetic core 150, the magnetic flux is strongly collected and the loss of the magnetic flux can be minimized.

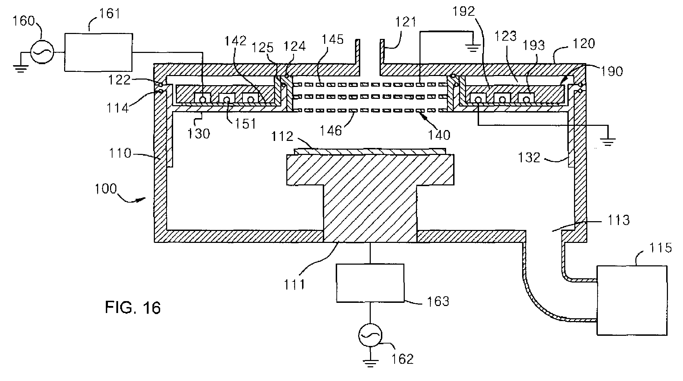

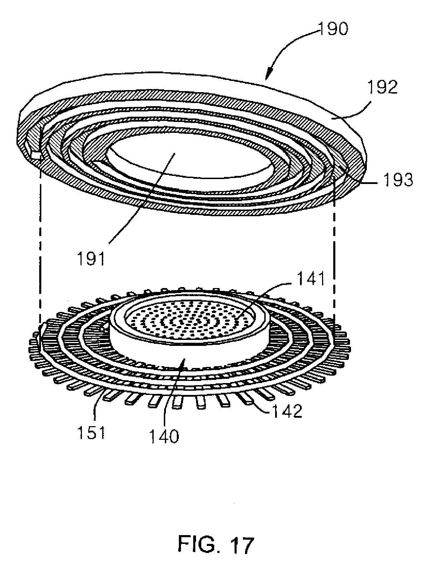

FIG. 16 is a cross-sectional view of a plasma reactor illustrating an example employing a plate type magnetic core. FIG. 17 is an exploded perspective view of the plate type magnetic core, a radio frequency antenna, and a shower head.

Referring to FIGS. 16 and 17, alternatively, the plate type magnetic core 190 may be used so as to cover the radio frequency antenna 151. The plate type magnetic core 190 has an opening 191 corresponding to the entire window 130 and has a plate type body 192 covering the entire upper potion of the dielectric window 130. An antenna mounting groove 193 is formed on the bottom surface of the plate type body 192 along a region where the radio frequency antenna 151 is located. The radio frequency antenna 151 is installed along the antenna mounting groove 193 and is covered by the plate type magnetic core 190 as a whole. The plate type magnetic core 190 may be used as an alternative embodiment of the horseshoe-shaped magnetic core 150.

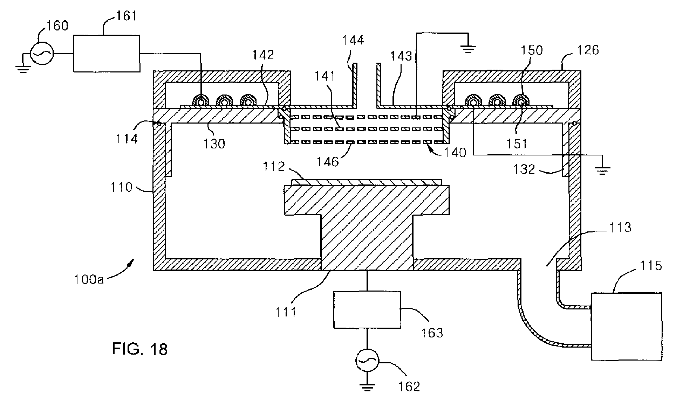

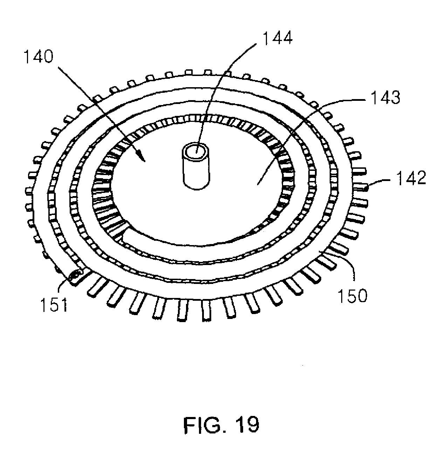

FIG. 18 is a cross-sectional view of a plasma reactor according to a fourth embodiment of the present invention. FIG. 19 is a view illustrating an arrangement structure of a radio frequency antenna installed at an upper portion of the plasma reactor and a gas shower head.

Referring to FIGS. 18 and 19, the plasma reactor of the fourth embodiment of the present invention has a basically same structure as the third embodiment. Therefore, the description of the same constitution will not be repeated. Meanwhile, the plasma reactor according to the fourth embodiment has a structure of a vacuum chamber 100a rather different from the vacuum chamber 100 of the third embodiment. In the vacuum chamber 100a of the plasma reactor of the fourth embodiment, a dielectric window 130 formed at an upper portion of a lower body 110 forms an upper cover. A cover member 126 covering a radio frequency antenna 151 and a magnetic core 150 as a whole is provided at an upper portion of the dielectric window 130. The cover member 126 may be formed of a conductive or non-conductive material. A shower head 140 further protrudes toward the substrate support 111 rather than the dielectric window 130.

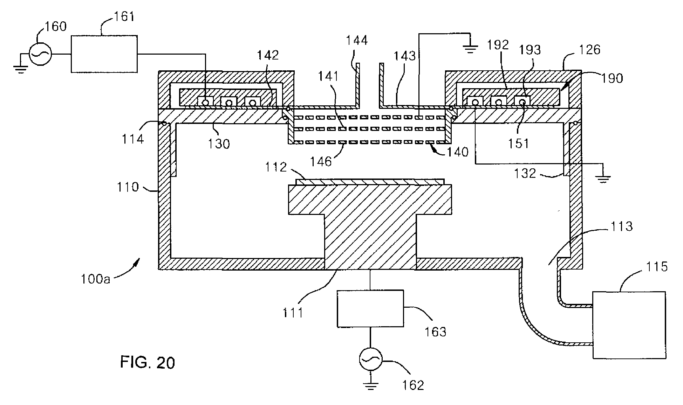

FIG. 20 is a cross-sectional view of a plasma reactor illustrating an example using a plate type magnetic core.

Referring to FIG. 20, as described in the third embodiment, a magnetic frequency antenna 151 may be covered using the plate type magnetic core 190.

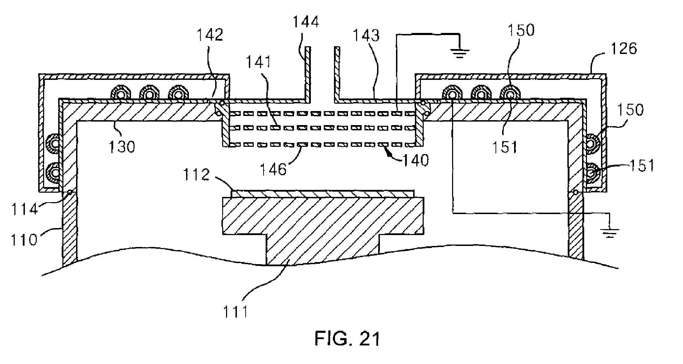

FIG. 21 is a view illustrating an example in which a cylindrical radio frequency antenna and a magnetic core are installed at an outer side wall portion of a vacuum chamber.

Referring to FIG. 21, the radio frequency antenna 151 has a flat plate spiral structure and is installed above the dielectric window 130. The radio frequency antenna 151 can be installed in a cylindrical structure on the outer side wall of the vacuum chamber 100 as an extended structure. The dielectric window 130 has a structure suitable for this and a magnetic core 150 is installed in the same way. Further, the cover member also has an extended structure so as to cover the radio frequency antenna 151 installed on the outer wall and the magnetic core 150.

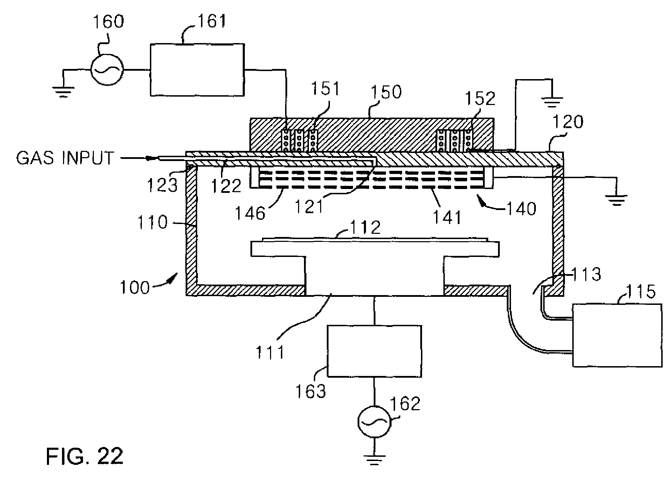

FIG. 22 is a cross-sectional view of a plasma reactor according to a fifth embodiment of the present invention.

Referring to FIG. 22, the inductively coupled plasma reactor includes a vacuum chamber 100 having a lower body 110 and a dielectric window 120 forming the ceiling of the lower body 110. A substrate support 111 on which a treated substrate 112 is positioned is provided in the interior of the vacuum chamber 100. The lower body 110 includes a gas outlet 113 for exhausting gas and the gas outlet 113 is connected to a vacuum pump 115.

A gas shower head 140 is installed in the inner upper portion of the vacuum chamber 100. The gas shower head 140 includes at least one gas distribution plate 141 and is formed of a conductive material. A silicon flat plate 146 having a plurality of gas injection holes may be installed in the gas shower head 140 at a section making contact with an interior region of the vacuum chamber 100.

A gas injection pipe 122 connected to the gas shower head 140 is installed in the dielectric window 120 and the distal end 121 of the gas injection pipe 122 is connected to the gas shower head 140. An O-ring 123 for vacuum insulation is installed between the dielectric window 130 and the lower body 110. A radio frequency antenna 151 is installed above the dielectric window 120 and the magnetic core 150 covering the radio frequency antenna 151 as a whole is installed.

One end of the radio frequency antenna 151 is electrically connected to a first power supply source 160 supplying radio frequencies through an impedance matcher 161 and the other end thereof is grounded. The radio frequency antennal 151 is inductively coupled to the plasma in the vacuum chamber. The substrate support 111 is electrically connected to a second power supply source 162 supplying radio frequencies through an impedance matcher 163 and the gas shower head 140 is grounded. The gas shower head 140 and the substrate support 111 constitute a pair of capacitive electrodes and are capacitively coupled to the plasma in the vacuum chamber 100. The first and second power supply sources 160 and 162 may be constituted using a radio frequency power supply source capable of controlling an output voltage without any separate impedance matcher. The phases of a radio frequency signal for capacitive coupling and a radio frequency signal for inductive coupling are related to some extent. For example, the phase relation of approximately 180 degrees is provided.

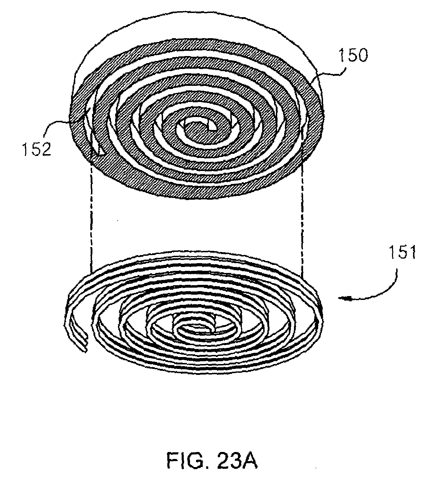

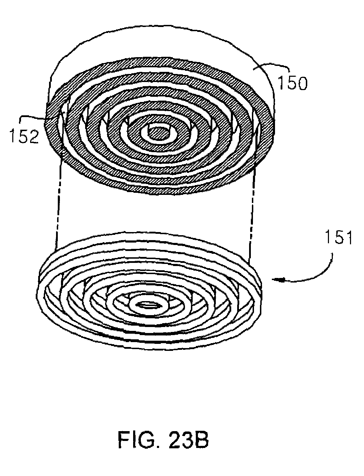

FIGS. 23A and 23B are views illustrating examples in which radio frequency antennas have a flat plate spiral shape or a concentric circular shape.

Referring to FIGS. 23A and 23B, the radio frequency antenna 151 includes at least one radio frequency antenna having a plurality of flat plate spiral or concentric circular structures. A plurality of radio frequency antennas 151 may overlap in at least two steps. A magnetic core 150 has a flat plate body covering the radio frequency antenna 151 as a whole. An antenna mounting groove 152 is formed spirally or concentrically along a region where the radio frequency antenna 151 is located.

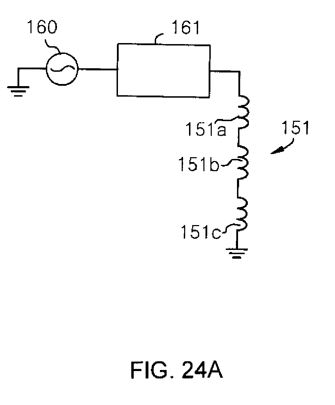

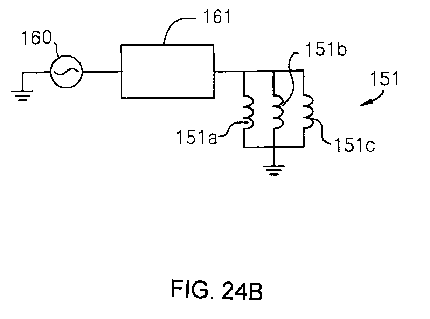

FIGS. 24A and 24B are views illustrating electrical connection structures of radio frequency antennas.

Referring to FIGS. 24A and 24B, the radio frequency antenna 151 may include a plurality of antenna units 151a, 151b, and 151c. The plurality of antenna units 151a, 151b, and 151c have electrical connection structures which are in series or in parallel and may have an electrical connection structure mixed with a series type and a parallel type.

In the inductively coupled plasma reactor of the present invention, the gas shower head 140 and the substrate support 111 are capacitively coupled to the plasma in the vacuum chamber 100 and the radio frequency antenna 151 is inductively coupled to the plasma in the vacuum chamber 100. Especially, since the radio frequency antenna 151 is covered by the magnetic core 150, the magnetic flux can be strongly collected and the loss of the magnetic flux can be minimized. The capacitive and inductive coupling allows generation of the plasma and accurate regulation of the plasma ion energy. Accordingly, the process productivity can be maximized. Further, since the gas shower head 140 is located above the substrate support 111, gas can be uniformly injected to an upper portion of the treated substrate 112, thereby treating the substrate more uniformly.

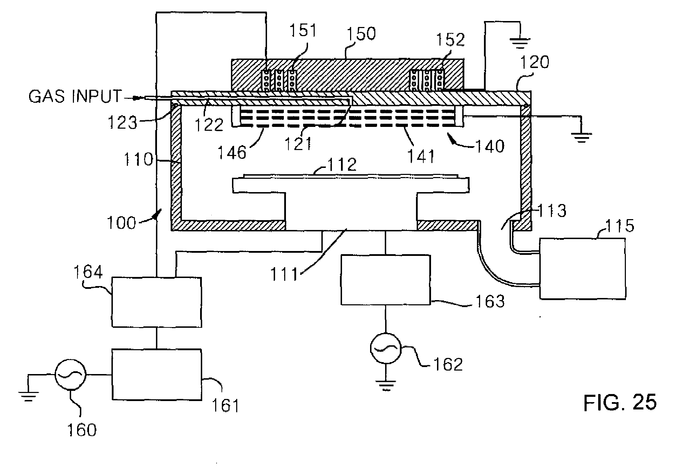

FIG. 25 is a view illustrating an example employing a dual power source supply structure by division of a power source. Referring to FIG. 25, a power source division and supply structure in which the radio frequency provided from a first power supply source 160 is distributed through a power source distributing section 164 and is supplied to a radio frequency antenna 151 and a substrate support 111. The power source distributing section 164 can divide a power source by various methods such as power source division using a transformer, power source division using a plurality of resistances, and power source division using a capacitor. The substrate support 111 receives the radio frequency divided from a first power supply source 160 and the radio frequency provided from a second power supply source 162. Here, the radio frequencies are different and are supplied from the first and second power supply sources 160 and 162.

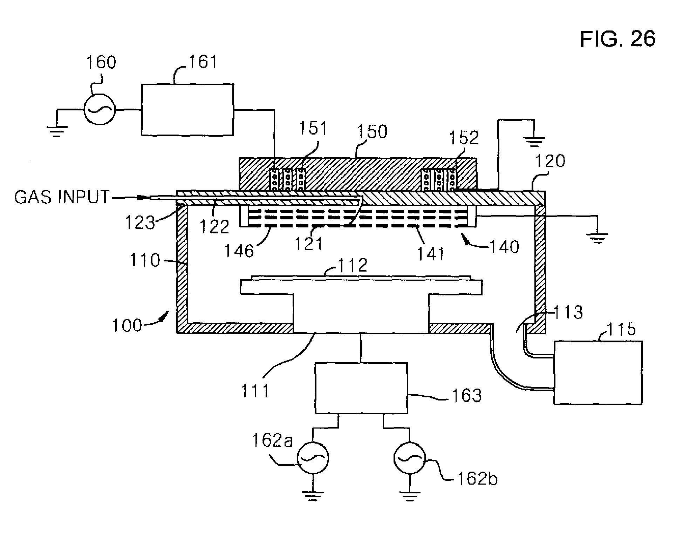

FIG. 26 is a view illustrating an example employing a dual power source structure with two power supply sources. Referring to FIG. 26, the substrate 111 can receive two radio frequencies through two power supply sources 162a and 162b providing two different frequencies.

If the substrate support 111 receives radio frequencies having different frequencies, various power source supply structure such as a power source division structure or a separate independent power source can be employed. The dual power source supply structure of the substrate support 111 facilitates generation of plasma in the interior of the vacuum chamber 100, improves regulation of plasma ion energy on a surface of the treated substrate 112, and improves the process productivity.

The single or dual power source supply structure of the substrate support 111 is combined with various electrical connection methods of the radio frequency antenna 151 and the gas shower head 140 which has been described in FIGS. 4A and 4D to realize various electrical connection methods.

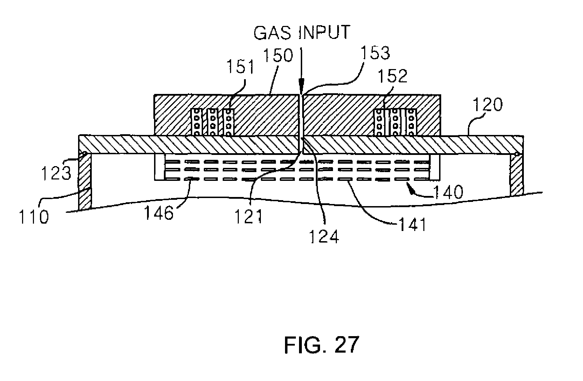

FIG. 27 is a partial cross-sectional view illustrating a modified example in which a gas supply channel is formed through a central portion of a magnetic core.

Referring to FIG. 27, in the gas supply structure, an opening 153 is formed at a central portion of the magnetic core 150 and an opening 124 corresponding to the opening 153 is also formed at a central portion of a dielectric window 120.

According to the inductively coupled plasma reactor of the present invention, the gas shower head and the substrate support are capacitively coupled to the plasma in the vacuum chamber and the radio frequency antenna is inductively coupled to the plasma in the vacuum chamber. Especially, since the radio frequency antenna is covered by the magnetic core, the magnetic flux can be strongly collected and the loss of the magnetic flux can be minimized. The capacitive and inductive coupling allows generation of plasma in the vacuum chamber and accurate control of plasma ion energy. Therefore, the yield and the productivity can be improved in semiconductor fabrication processes. Further, since the gas shower head uniformly injects gas above the substrate support, the substrate can be treated uniformly.

The plasma reactor according to the present invention can be variously modified and can take various forms. However, the present invention should not be construed to be limited to a particular shape and it is understood that the present invention includes all modifications and equivalents in the scope of the present invention which is defined by the claims.

## Claims

1. A plasma reactor comprising:
a vacuum chamber (100) having a substrate support (111) on which a treated substrate (112) is positioned;
a gas shower head (140) for supplying gas into the interior of the vacuum chamber (100);
a dielectric window (130) installed at an upper portion of the vacuum chamber; and
a radio frequency antenna (151) installed above the dielectric window,
wherein the gas shower head and the substrate support are capacitively coupled to plasma in the interior of the vacuum chamber and the radio frequency antenna is inductively coupled to the plasma in the interior of the vacuum chamber.

2. The plasma reactor according to claim 1, wherein the dielectric window (130) has an opening at a central portion thereof and the gas shower head (140) is installed in the opening of the dielectric window.

3. The plasma reactor according to claim 2, wherein the radio frequency antenna (151) is installed around the gas shower head (140) above the dielectric window (130).

4. The plasma reactor according to any preceding claim, wherein the gas shower head is installed above the substrate support (111) in the interior of the vacuum chamber (100).

5. The plasma reactor according to any one of claims 1 to 4, further comprising:
a magnetic core (150) installed above the dielectric window (130) so as to cover the radio frequency antenna (151).

6. The plasma reactor according to claim 5, wherein the magnetic core (150) is installed above the dielectric window (130) so that an entrance of a magnetic flux faces the interior of the vacuum chamber (100) and covers the radio frequency antenna (151).

7. The plasma reactor according to claim 5, wherein the magnetic core (150) comprises a flat plate type body covering the radio frequency antenna (151) as a whole and an antenna mounting groove formed on the bottom surface of the flat plate type body along a region where the radio frequency antenna is positioned.

8. The plasma reactor according to claim 7, wherein the magnetic core (150) has an opening corresponding to a region where the gas shower head (140) is installed.

9. The plasma reactor according to any preceding claim, further comprising:
a faraday shield (142) installed between the radio frequency antenna (151) and the dielectric window.

10. The plasma reactor according to any preceding claim, further comprising:
a first power supply source (160) connected to the radio frequency antenna and adapted to supply a radio frequency; and
a second power supply source (162) adapted to supply a radio frequency to the substrate support.

11. The plasma reactor according to claim 10, further comprising:
a third power supply source adapted to supply a radio frequency different from that of the second power supply source to the substrate support.

12. The plasma reactor according to any preceding claim, further comprising:
a first power supply source (160) for supplying a radio frequency; and
a power source division section for dividing radio frequency power provided from the first power supply source (160) and for supplying the divided radio frequency power to the radio frequency antenna (151) and the substrate support (111).

13. The plasma reactor according to claim 12, further comprising:
a second power supply source (162) supplying a radio frequency different from that of the first power supply source (160) to the substrate support (111).

14. The plasma reactor according to any one of claims 10 to 13, further comprising:
a power regulating section connected either between the radio frequency antenna and the ground or between the gas shower head and the ground.

15. The plasma reactor according to any one of claims 10 to 13, wherein the radio frequency antenna (151) and the gas shower head (140) are connected in series between the first power supply source (160) and the ground, and either one end of the radio frequency antenna is connected to the ground or the gas shower head is connected to the ground.

16. The plasma reactor according to claim 15, wherein the power regulating section is connected either between the radio frequency antenna (151) and the ground or between the gas shower head (140) and the ground.

17. The plasma reactor according to any one of claims 10 to 13, wherein the radio frequency antenna (151) has at least two separated structures, the at least two separated structures of the radio frequency antenna (151) and the gas shower head (140) are connected in series between the first power supply source (160) and the ground, and the gas shower head is connected between two separated structures of the radio frequency antenna.

18. The plasma reactor according to claim 17, further comprising:
a power regulating section connected either between the radio frequency antenna (151) and the ground or between the gas shower head or the ground.

19. The plasma reactor according to any preceding claim, wherein the dielectric window, the radio frequency antenna, and the magnetic core are installed on the inner side of the vacuum chamber and the plasma reactor further comprises an upper cover covering an upper portion of the vacuum chamber.

20. The plasma reactor according to any preceding claim, wherein the dielectric window functions as an upper cover of the vacuum chamber and the plasma reactor further comprises a cover member covering the radio frequency antenna and the magnetic core as a whole above the dielectric window.

21. The plasma reactor according to any preceding claim, further comprising:
a dielectric wall (132) installed along the inner wall of the vacuum chamber (100).

22. The plasma reactor according to any preceding claim, wherein the gas shower head (140) makes contact with an inner region of the vacuum chamber (100) and comprises a silicon flat plate having a plurality of gas injection holes.

23. The plasma reactor according to any preceding claim, wherein the radio frequency antenna (151) has one of a spiral structure and a centric circular structure.

24. The plasma reactor according to any preceding claim, wherein the radio frequency antenna (151) is stacked in at least two steps.

25. A plasma reactor comprising a vacuum chamber, a dielectric window installed at an upper portion of the vacuum chamber, and a radio frequency antenna installed above the dielectric window, the plasma reactor comprising:
a magnetic core installed above the dielectric window so that an entrance for a magnetic flux faces the interior of the vacuum chamber and covers the radio frequency antenna.

26. The plasma reactor according to claim 25, wherein the magnetic core has a structure simultaneously covering at least one radio frequency antenna.

27. The plasma reactor according to claim 25, wherein when the radio frequency antenna has a spiral structure or a concentric circular structure, the magnetic core has a spiral structure or a concentric circular structure in correspondence to the structure of the radio frequency antenna.

28. The plasma reactor according to claim 25, wherein the radio frequency antenna has a stacked structure in at least two steps and the magnetic core simultaneously covers the stacked radio frequency antenna.
